# EUROPÄISCHE PATENTSCHRIFT

(11) **EP 0 646 221 B1**
(45) Veröffentlichungstag und Bekanntmachung des Hinweises auf die Patenterteilung: **21.05.1997**
(21) Anmeldenummer: 93912566.2
(22) Anmeldetag: 08.06.1993
(51) Int. Cl.: F15C 5/00, H01L 41/12

(54) **MAGNETOSTRIKTIVER WANDLER**
MAGNETOSTRICTIVE TRANSDUCER
TRANSDUCTEUR MAGNETOSTRICTIF

(30) Priorität: 20.06.1992 DE 4220226
(43) Veröffentlichungstag der Anmeldung: 05.04.1995
(73) Patentinhaber: ROBERT BOSCH GMBH, 70442 Stuttgart (DE)
(72) Erfinder: FRIEDRICH, Heinz, D-71292 Friolzheim (DE); TREUTLER, Christoph, D-7415 Wannweil (DE); BENZ, Gerhard, D-7030 Böblingen (DE); FLIK, Gottfried, D-7250 Leonberg (DE)
(86) Internationale Anmeldenummer: DE9300489
(87) Internationale Veröffentlichungsnummer: WO9400695

(56) Entgegenhaltungen:
- EP-A- 0 161 397
- EP-A- 0 401 607
- US-A- 3 370 538
- US-A- 3 638 153
- PATENT ABSTRACTS OF JAPAN vol. 13, no. 147 (E-741)11. April 1989 & JP-A-63 308 980 (MATSUSHITA) 16 December 1988
- PATENT ABSTRACTS OF JAPAN vol. 12, no. 63 (E-585)25. Februar 1988 & JP-A-62 204 504 (NIPPON TELEGR & TELEPH) 9 September 1987
- JAPANESE JOURNAL OF APPLIED PHYSICS Bd. 28, Nr. 28-1, März 1989, Seiten 132 - 134 , XP000085275 INOUE 'multilayerd magneto-surface-acoustic-wave device'

## Beschreibung

### Stand der Technik

Die Erfindung geht aus von einem magnetostriktiven Wandler nach der Gattung des Hauptanspruchs. Ein solcher magnetostriktiver Wandler ist aus der US-A-3 370 538 bekannt. Aus der Firmenschrift "Application Manual for the Design of Extrema Terfenol Magnetostrictive Transducers" der Firma Edge Technologies, Inc. ist bereits ein magnetostriktiver Wandler bekannt, der eine stromdurchflossene Spule und einen darin angeordneten Stab aus einer Terbium-Dysprosium-Eisen-Legierung aufweist. Weiterhin ist aus der DE-A1 40 03 619 ein Mikroventil bekannt, bei dem durch eine parallel zum eintretenden Fluidstrahl liegende Biegezunge der Fluidstrahl in einen von zwei Auslaßkanälen lenkbar ist. Dabei wird die Biegezunge thermomechanisch betrieben. Weiterhin ist aus der DE-A1 39 19 876 ein Mikroventil bekannt, bei dem ein an piezoelektrisch betriebenen Biegeelementen aufgehängter Dichtblock einen Auslaß verschließen kann. Das Abscheiden von dünnen Metallschichten aus einem Metalldampf wird beispielsweise in einem Buch von Sze,VLSI Technologie, McGraw-Rill International, Seite 347 bis 367 beschrieben.

### Vorteile der Erfindung

Der erfindungsgemäße magnetostriktive Wandler mit den kennzeichnenden Merkmalen des Hauptanspruchs hat demgegenüber den Vorteil, daß die dünnen Schichten auch als Antriebe für sehr kleine Wandler geeignet sind. Durch die Anwendung in Biegeelementen können dabei trotzdem sehr große Auslenkungen erreicht werden. Weiterhin können durch die dünnen magnetostriktiven Schichten im Verhältnis zu ihrer Kleinheit sehr hohe Kräfte erzeugt werden. Weiterhin ist es als Vorteil anzusehen, daß die dünnen magnetostriktiven Schichten keine unmittelbaren Zuleitungen benötigen und somit auch an Stellen einsetzbar sind, zu denen eine elektrische Zuleitung nur unter großen Problem erfolgen könnte. Weiterhin können Wandler mit magnetostriktiven Dünnschichten mit sehr hohen Frequenzen betrieben werden und weisen ein besseres Dynamisches Verhalten auf auf als z.B. makroskopische Stäbe.

Durch in den Unteransprüchen aufgeführten Maßnahmen sind vorteilhafte Weiterbildungen und Verbesserungen des im Hauptanspruch angegebenen magnetostriktiven Wandlers möglich. Einen hohen magnetostriktiven Effekt d.h. eine große relative Längenänderung zeigen die dünnen Schichten, wenn sie amorph sind oder eine nanokristalline Struktur aufweisen. Solche Schichten zeichnen sich auch durch eine geringe Hysterese des magnetostriktiven Effektes aus. Durch Strukturierung können die dünnen Schichten an den Stellen angeordnet werden, wo hohe Zugbzw. Druckspannungen erzeugt werden sollen um große Stellwege der Biegewandler zu erzielen. Es können so eine Vielzahl von miniaturisierten magnetostriktiven Wandlern gleichzeitig auf einer Substratplatte hergestellt werden. Durch die Zerlegung der dünnen Schicht in viele einzelne, elektrisch getrennte Bereiche werden Wirbelströme in der dünnen Schicht unterdrückt und so das dynamische Verhalten der magnetostriktiven Schicht verbessert. Die Biegeelemente sind als Biegebalken oder Membranen ausformbar. Durch das Tempern oder Abscheiden in einem äußeren Magnetfeld wird eine magnetische Vorzugsrichtung die Richtung der sog. leichten Magnetisierung in den dünnen Schichten erzeugt.

Schon bei niedrigen äußeren Magnetfeldern von 500 Oersted wird eine hohe Magnetostriktion in der Größenordnung von einigen 10⁻⁴ erreicht, wenn das Magnetfeld parallel zur Vorzugsrichtung, d.h. parallel zur Richtung der leichten Magnetisierung angelegt wird. Ohne spezielle Vorkehrungen liegt diese Vorzugsrichtung bei amorphen Proben meist in der Schichtebene. Durch Tempern in einem äußeren Magnetfeld oder bereits durch Abscheidung in einem äußeren Magnetfeld kann zum einen die erreichbare Magnetostriktion der Schichten weiter erhöht als auch die Vorzugsrichtung beliebig eingestellt werden. Dadurch können Biegewandler realisiert werden, die hohe Auslenkungen bei niedrigen äußeren Feldern aufweisen, wobei das äußere Feld sowohl senkrecht als auch parallel zur magnetostriktiven Dünnschicht orientiert sein kann.

Durch die Einbettung der dünnen magnetostriktiven Schicht in weitere dünne Schichten aus einem weichmagnetischen Material wird das äußere Magnetfeld im Bereich der dünnen magnetostriktiven Schicht verstärkt, so daß mit geringen äußeren Magnetfeldern große Kräfte erzeugt werden können. Die Maßnahmen zur Verstärkung des magnetostriktiven Effektes erlauben die Verwendung von besonders einfachen Spulen zur Erzeugung des Magnetfeldes. Die Spulen können beispielsweise in Dickfilmtechnik ausgeführt sein. Ein besonders attraktives Anwendungsgebiet für den magnetostriktiven Wandler ist die Anwendung in Ventilen, da hier relativ große Kräfte notwendig sind und es schwierig ist, elektrische Leitungen in das Innere des Ventils hereinzuführen. Wird bei diesem Ventil der Auslaß durch einen Biegewandler verschlossen, so kann durch eine Schwingung des Biegewandlers eine Zerstäubung des austretenden Mediums unterstützt werden. Besonders kleine Ventile können aus Siliziumwafern herausstrukturiert werden, aber auch metallische Substratplatten sind für die magnetostriktiven Wandler geeignet..

### Zeichnungen

Ausführungsbeispiele der Erfindung sind in den Zeichnungen dargestellt und in der nachfolgenden Beschreibung näher erläutert. Es zeigen Figur 1 eine dünne Schicht auf einem Substrat, Figuren 2, 3 und 4 eine dünne Schicht auf einer Biegezunge, Figur 5 eine Sputteranlage zur Abscheidung der dünnen Schicht, Figur 6 eine dünne Schicht, die in zwei weichmagnetische Schichten eingebettet ist, Figur 7 ein erstes Ausführungsbeispiel eines magnetostriktiven Ventils und Figur 8 ein weiteres Ausführungsbeispiel eines magnetostriktiven Ventils.

### Beschreibung der Ausführungsbeispiele

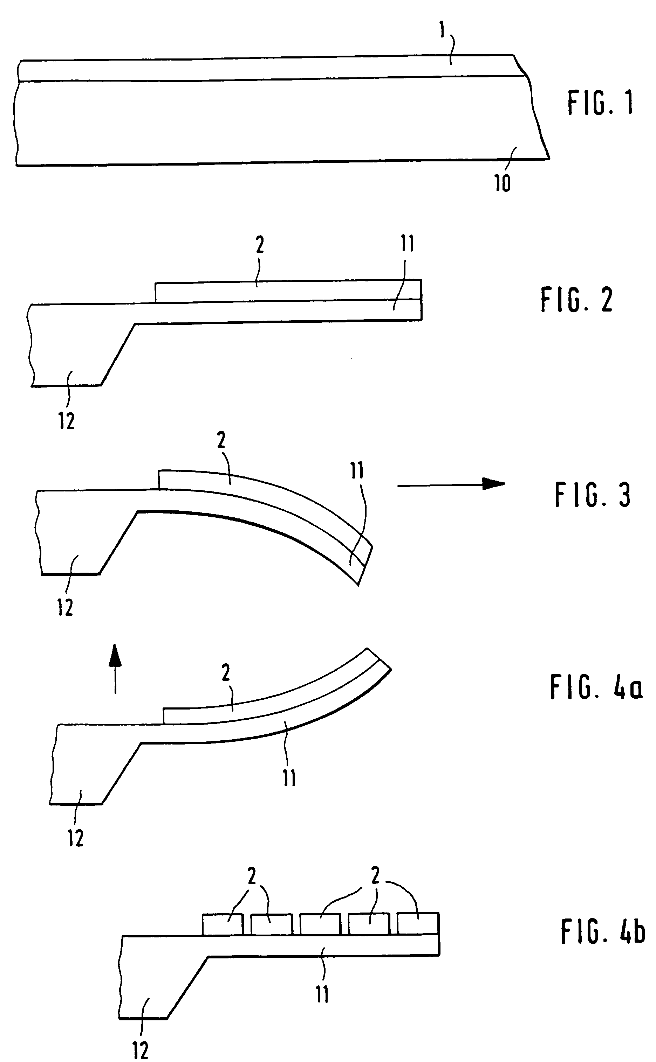

In der Figur 1 ist mit 10 ein Siliziumwafer bezeichnet, auf dem eine dünne magnetostriktive Schicht 1 abgeschieden ist. Die dünne Schicht 1 besteht aus den Elementen Terbium, Dysposium und Eisen, wobei die Zusammensetzung durch die Summenformel Tb₍₁₋ₓ₎ Dy₍ₓ₎Fe₂ mit 0<x<1 gegeben ist. Vorzugsweise ist dabei x in der Größenordnung von 0,75 +/- 0,11. Die Mikrostruktur der dünnen Schicht ist dabei vorzugsweise amorph. Als amorphe Schichten sind hier Schichten zu verstehen, die im Durchstrahlungselektronenmikroskop im Beugungsmodus keine Beugungserscheinungen zeigen. Gute magnetostriktive Eigenschaften der dünnen Schicht 1 sind auch noch mit nanokristallinen Schichten zu realisieren, die einen Korndurchmesser von weniger als 50 Nanometern aufweisen. Bei grobkristallinen Schichten werden im Gegensatz zu amorphen Schichten stark ausgeprägte Hystereseeigenschaften beobachtet. Grobkristalline Schichten eignen sich deshalb nicht für die Anwendung bei geringen äußeren Magnetfeldern. Durch übliche Techniken wie Aufbringen eines Fotolacks, Fotolithograhie und anschließende Ätzung kann die dünne Schicht 1 strukturiert werden, so daß eine strukturierte dünne magnetostriktive Schicht 2 entsteht, wie sie beispielsweise in der Figur 2 gezeigt wird. Die Ätzung der dünnen Schicht 1 erfolgt beispielsweise durch ein Gemisch von Salzsäure, Salpetersäure und Wasser. Der Siliziumwafer 10 wird so strukturiert, daß der Biegebalken 11 entsteht, der am Rahmen 12 aufgehängt ist. Die dazu benötigten Methoden der Siliziummikromechanik sind dem Fachmann geläufig.

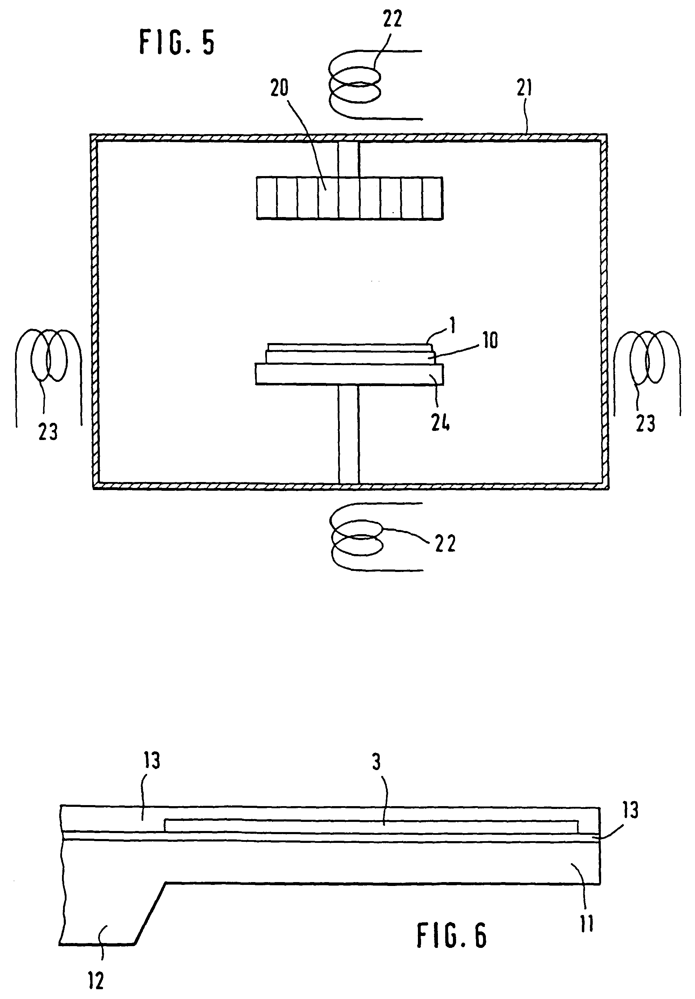

In den Figuren 3 und 4 ist der Effekt eines äußeren Magnetfelds auf den Biegebalken 11 mit aufgebrachten magnetostriktiver Dünnschicht 2 in Abhänigkeit von der Richtung des Magnetfelds gezeigt. Die Ausgangslage, d.h. die Lage des Biegebalkens 11 ohne ein Magnetfeld entspricht der in der Figur 2 gezeigten Position. Dabei wird bei der Figur 2 davon ausgegangen, daß bei der Abscheidung der dünnen Schicht 1 auf dem Wafer 10 keine inneren Spannungen im Verbund bestehend aus magnetostriktiven Schicht 1 und dem Wafer 10 erzeugt wurde. Dies ist bei der Verwendung von Siliziumwafern als Substrat jedoch in der Praxis nur schwer zu erreichen, da die Abscheidung der dünnen magnetostriktiven Schicht in der Regel bei höheren Temperaturen erfolgt und der thermische Ausdehnungskoeffizient von TbDyFe-Legierungen wesentlich größer ist als der von einkristallinem Silizium. Es ist jedoch möglich, die Abscheidung so zu beeinflussen, daß spannungsfreie Metallschichten auf Siliziumwafern erzeugt werden können. Bei der Figur 2 wird davon ausgegangen, daß keine Verspannungen zwischen der dünnen magnetostriktiven Schicht 2 und dem Biegebalken 11 bestehen. Zur Verringerung thermisch bedingter innerer Spannungen muß das Siliziumsubstrat besonders gut gekühlt werden. In diesem Fall ist es möglich, die Abscheidung so zu beeinflussen, daß nahezu spannungsfreie TbDyFe-Schichten auf Siliziumwafern erzeugt werden. Vorteilhafter bei Verwendung von Metallsubstraten wie Stahl oder Nickel ist, daß die thermischen Ausdehnungskoeffizienten besser an die der TbDyFe-Schicht angepaßt sind.

In der Figur 3 wird die Wirkung eines Magnetfeldes, das parallel zur Längsseite des Biegebalkens 11 ist gezeigt. Ein magnetostriktives Material dehnt sich in Richtung des Magnetfeldes aus. Da das Magnetfeld, wie durch den Pfeil angedeutet, parallel zur Ausgangslage des Biegebalkens 11 ist, wird die dünne Schicht 2 länger und der Biegebalken 11 wird zu der Seite ausgelenkt, auf der keine dünne Schicht 2 gelegen ist, in diesem Fall nach unten. In der in Figur 3 gezeigten Anordnung wird die Dynamik des Biegewandlers nur unwesentlich durch Wirbelströme behindert, die in der Schicht entstehen können. Wirbelströme entstehen im wesentlichen nur in einer Ebene senkrecht zum Magnetfeld, die hier verwendete Dicken von einem bis 20 Mikrometer sind jedoch zu gering, als daß sich Wirbelströme in wesentlichem Umfang ausbilden könnten.

In der Figur 4 ist die Wirkung eines Magnetfeldes dargestellt, das senkrecht zur Längsrichtung des Biegebalkens 11 orientiert ist, wie durch den Pfeil angedeutet. Die magnetostriktive Schicht 2 dehnt sich in Richtung des Magnetfeldes aus. Durch diese Ausdehnung allein kann jedoch keine Verbiegung des Biegebalkens 11 bewirkt werden. Da jedoch in erster Näherung das Volumen der magnetostriktiven Dünnschicht 2 erhalten bleibt, zieht sie sich in der Richtung, die senkrecht zum B-Feld ist, d.h. parallel zum Biegebalken 11, zusammen. Durch die Längenverkürzung der dünnen Schicht 2 wird somit eine Auslenkung des Biegebalkens 11 zu der Seite bewirkt, auf der die dünne Schicht 2 angeordnet ist. Da es sich hierbei jedoch um einen indirekten Effekt handelt, sind die erzielbaren Auslenkungen bei ansonsten gleichen Dimensionen wie in der Figur 3 geringer. Vorteilhaft an dieser Orientierung des Magnetfeldes ist jedoch, daß Spulen, die ein Magnetfeld erzeugen, das senkrecht zum Biegebalken 11 orientiert sind, unter Umständen leichter und kostengünstiger herzustellen sind als Spulen, die ein Magnetfeld parallel zum Biegebalken 11 erzeugen.

In der Anordnung nach Figur 4 können Wirbelströme im Vergleich zur Anordnung nach Figur 3 leichter indiziert werden. In der Figur 4a ist daher eine Strukturierung der magnetostriktiven Dünnschicht 2 gezeigt, durch die die Ausbildung von Wirbelströmen weitgehend unterdrückt wird. Um den Wirbelstrompfad zu unterbrechen, ist die magnetostriktive Schicht 2 fotolithographisch in elektrisch getrennte Teilbereiche geteilt. Wirbelströme führen bei einer hohen Frequenz des äußeren Magnetfelds zu einer unerwünschten Aufwärmung des Wandlers und zu einer Schwächung des Magnetfeldes und verhindern so, daß die dünne Schicht 2 entsprechend schnell auf das Magnetfeld reagiert.

Die in den Figuren 3 und 4 beschriebenen Effekte in Abhängigkeit von der Orientierung des Magnetfeldes bleiben erhalten, wenn der Biegebalken aufgrund innerer Spannungen zwischen dem Biegebalken 11 und der dünnen Schicht 2 bereits in dem Zustand, in dem kein äußeres Magnetfeld vorhanden ist, ausgelenkt ist.

In der Figur 5 wird die Herstellung der dünnen Schicht 1 auf einem Wafer 10 in einer Sputteranlage beschrieben. In einem Vakuumkessel 21 wird zwischen einem Target 20 und dem Wafer 10 ein Argonplasma erzeugt, das so auf das Target 20 gelenkt wird, daß Metallatome vom Target 20 herausgeschlagen werden. Aus der Gasphase scheiden sich dann die Metallatome auf der Oberfläche des Wafers 10 ab. Dabei ist darauf zu achten, daß der Sauerstoffbzw. der Wasseranteil in der Argonatmosphäre so gering wie möglich gehalten wird, um eine Oxidation von Terbium und Dysprosium zu vermeiden. Das Target 20 ist als sog. Mosaiktarget ausgebildet, d.h. es besteht aus einzelnen Stücken der drei Elemente Terbium, Dysprosium und Eisen. Die Flächen sind dabei so gewählt, daß die gewünschte Zusammensetzung der dünnen Schicht 1 erreicht wird. Alternativ kann auch ein Legierungstarget verwendet werden. Der Wafer 10 ist auf einem Substrathalter angeordnet, der gekühlt und beheizt werden kann. Weiterhin ist der Substrathalter drehbar gelagert, um die Homogenität der Schichtzusammensetzung zu verbessern. Außerdem kann an den Substrathalter eine elektrische Spannung, die sog. Bias-Spannung angelegt werden, durch die ebenfalls die Qualität der Abscheidung beeinflußt werden kann. Weiterhin sind Spulen 22 und 23 vorhanden, von denen die Spule 22 ein Magnetfeld erzeugt, das senkrecht auf dem Wafer steht und die Spule 23 ein Magnetfeld erzeugt, das parallel zur Oberfläche des Wafers ist.

Mit Hilfe der Spulen 22, 23 kann sowohl die Höhe der erreichbaren Magnetostriktion (die sog. Sättigungsmagnetostriktion), als auch die sog. Richtung der leichten Magnetisierung beeinflußt werden. Wenn das zur Betätigung eines Biegewandlers notwendige äußere Magnetfeld parallel zur Richtung der leichten Magnetisierung liegt, so wird schon bei einem geringen äußeren Magnetfeld eine hohe magnetostriktiv verursachte Längenänderung erzielt. Liegt dagegen das äußere Magnetfeld senkrecht zur leichten Magnetisisierung, so werden zum Erreichen eines vergleichbaren magnetostriktiven Effekts vergleichsweise hohe Magnetfelder benötigt, die nur mit großem Aufwand hergestellt werden können. Für leistungsfähige und kostengünstig herzustellende Biegewandler ist es daher vorteilhaft, wenn die Richtung des äußeren Magnetfelds mit der Richtung der leichten Magnetisierung übereinstimmt.

Bei der Schichtabscheidung ohne Betrieb der äußeren Magnetspulen 22, 23 liegt die Richtung der leichten Magnetisierung im allgemeinen in der Schichtebene, d.h. parallel zur Oberfläche des Substrates. Durch Abscheiden der Schicht im Magnetfeld der Spule 23 bleibt die Vorzugsrichtung in der Schichtebene erhalten, es wird aber bei vergleichsweise niedrigeren äußeren Magnetfeldern ein wesentlich höherer magnetostriktiver Effekt erzielt als bei einer Abscheidung ohne Betrieb der Spule 23. Durch Abscheiden der Schicht im Magnetfeld der Spule 22 kann die Richtung der leichten Magnetisierung senkrecht zur Schichtebene eingestellt werden. Dadurch wird ein hoher magnetostriktiver Effekt bei niedrigen, senkrecht zur Schichtebene orientierten äußeren Magnetfeldern erreicht.

Eine weitere Möglichkeit besteht darin, durch den Heizer 24 die dünne Schicht 1 zu erwärmen und in einem äußeren Magnetfeld wieder abzukühlen. Dabei sollten jedoch Temperaturen von ca. 350°C nicht überschritten werden, da sonst eine Rekristallisation der amorphen dünnen Schicht 1 verursacht wird, die mit einer Zunahme der Hysterese verbunden ist.

In der Figur 6 ist eine weitere vorteilhafte Ausgestaltung eines am Rahmen 12 aufgehängten Biegebalkens 11 mit einer dünnen magnetostriktiven Schicht 3 gezeigt. Die dünne magnetostriktive Schicht 3 ist in dünne weichmagnetische Schichten 13 mit geringer Hysterese und großer magnetischer Suszeptibilität wie beispielsweise einer FeNi-Legierung, die unter dem Handelsnamen Permalloy bekannt ist, eingebettet. Durch das weichmagnetische Material der dünnen Schichten 13 wird eine Verstärkung des äußeren Magnetfeldes erreicht. Durch diese Maßnahme können somit niedrigere magnetische Feldstärken bzw. einfachere Spulen zur Erzeugung des Magnetfeldes verwendet werden. Eine solche weichmagnetische Schicht kann zusätzlich auch als Schutzschicht zur Verhinderung von unerwünschten Alterungseffekten z.B. durch Reaktion mit Sauerstoff aus der Atmosphäre dienen. Die Verwendung von anderen Schutzschichten, beispielsweise aus Siliziumnitrid, Glas, Nickel-Chrom-Legierung oder Titannitrid ist ebenfalls möglich.

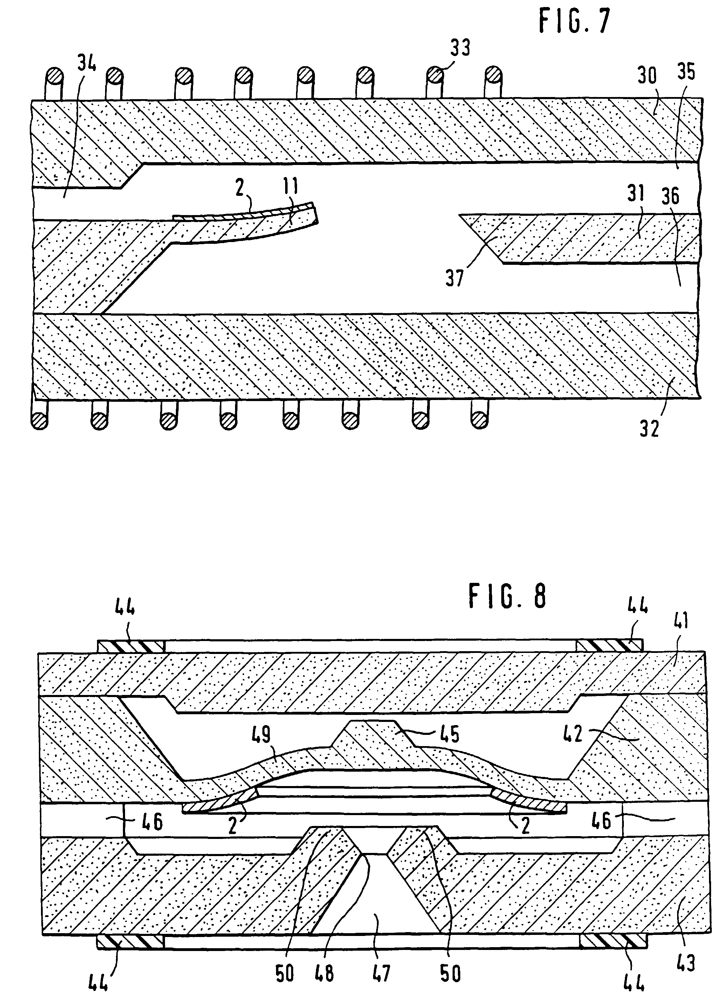

In der Figur 7 ist eine erste Anwendung der magnetostriktiven Schicht 2 auf einem Biegebalken 11 in einem Mikroventil gezeigt. Das hier gezeigte Mikroventil ist in ähnlicher Weise mit einem thermomechanischen Antrieb in der DE-A1 40 03 619 beschrieben. Das Mikroventil ist aus drei strukturierten Silizumplatten 30, 31, 32 aufgebaut. Aus der mittleren Siliziumplatte 31 ist der Biegebalken 11 und der Strahlteiler 37 herausstrukturiert. Durch die entsprechenden Strukturen der oberen Siliziumplatte 30 und der mittleren Siliziumplatte 31 ist der Einlaß 34 und der Auslaß 35 gebildet. Durch die entsprechende Strukturierung der mittleren Siliziumplatte 31 und der unteren Siliziumplatte 32 ist der Auslaß 36 erzeugt. Das Ventil ist von einer äußeren Spule 33 umgeben, die ein Magnetfeld erzeugt, welches parallel zum Biegebalken 11 orientiert ist. Der Biegebalken 11 ist hier in der Ausgangslage, d.h. ohne ein äußeres Magnetfeld gezeigt. Aufgrund von inneren Spannungen zwischen der dünnen Schicht 2 und dem Biegebalken 11 ist der Biegebalken 11 leicht nach oben verbogen. Ein durch den Einlaß 34 eintretender Fluidstrahl wird so vom Biegebalken 11 in den Auslaß 35 gelenkt. Wenn nun durch die Spule 33 ein äußeres Magnetfeld erzeugt wird, so dehnt sich die dünne Schicht 2 aus. Dies hat zur Folge, daß wie eingangs zu Figur 3 beschrieben, der Biegebalken zu der Seite verbiegt, auf der keine dünne Schicht 2 gelegen ist, d.h. in diesem Fall nach unten. Da der durch den Einlaß 34 eintretende Fluidstrahl an der Oberseite des Biegebalken 11 haftet, wird er, wenn der Biegebalken 11 nach unten ausgelenkt wird, so gegen den Strahlteiler 37 gelenkt, daß der Fluidstrahl durch den Auslaß 36 das Ventil verläßt. Durch das durch die Spule 33 erzeugte Magnetfeld kann so der Fluidstrahl beliebig zwischen den beiden Auslässen 35 und 36 hin und her geschaltet werden.

Die Spule 33 ist hier als normale Luftspule ausgebildet. Vorteilhaft an diesem Ventilaufbau ist insbesondere, daß der magnetostriktive Effekt durch die Richtung des Magnetfeldes entsprechend Figur 3 besonders groß ist. Weiterhin werden keine elektrischen Zuleitungen im Inneren des Ventils benötigt. Dadurch vereinfacht sich der Aufbau des Ventils erheblich. Nachteilhaft an dieser Anordnung ist, daß Ventil und Spule einzeln zusammengeführt werden müssen.

In der Figur 8 ist eine weitere Ausführung eines Mikroventils gezeigt, die sich weitgehend am Mikroventil orientiert, das in der DE-A1 39 19 876 beschrieben ist. Das dort beschriebene Ventil ging jedoch von einem piezoelektrischen Antrieb aus. Ein besonderer Vorteil des Mikroventils nach der Figur 8 ist, daß das gesamte Ventil parallel in einer Vielzahl von Ventilen aus einem Substrat gefertigt werden kann. Insbesondere ist es nicht notwendig, Ventilkörper und die Spule für die Erzeugung des Magnetfeldes separat zu fertigen und dann in einem weiteren Schritt zusammenzufügen. Das Ventil ist aus drei Siliziumplatten 41, 42, 43 aufgebaut, wobei aus der mittleren Siliziumplatte 42 eine Membran 49 mit einem auf der Membran liegenden Dichtblock 45 ausgebildet ist. Dieser dient als Anschlag zur Begrenzung des Öffnungsquerschnitt und führt zu einem besseren Dichtverhalten. Durch die entsprechenden Strukturen der mittleren Siliziumplatte 42 bzw. der unteren Siliziumplatte 43 ist der Einlaß 46 gebildet. Weiterhin weist die untere Siliziumplatte 43 eine Öffnung, den Auslaß 47, auf der von einem Ventilsitz 50 umgeben ist. Der Auslaß 47 ist durch entsprechende Ätzprozesse so strukturiert worden, daß er eine scharfe Kante, die sog. Abrißkante 48 aufweist. Auf der Oberseite der Siliziumplatte 41 und der Unterseite der Siliziumplatte 43 sind durch Dickfilmtechnik Leiterbahnen für eine Dickfilmspule 44 aufgebracht. Alternativ kann die Spule aus in Dünnfilmtechnik hergestellt werden, wobei die Leiterbahnen durch galvanische Prozesse in ihrer Dicke verstärkt werden können. Auf der Membran 49 ist die dünne magnetostriktive Schicht 2 aufgebracht.

Durch die Dickfilmspule 44 wird ein Magnetfeld erzeugt, das ungefähr senkrecht auf der Oberfläche der dünnen Schicht 2 steht. Durch dieses Magnetfeld wird somit, wie zuvor zu der Figur 4 beschrieben, ein Zusammenziehen der dünnen Schicht 2 in der Richtung die senkrecht zum Magnetfeld d.h. parallel zur Oberfläche der Membran 49 ist verursacht. Die Membran 49 wird so zu der Seite ausgelenkt, auf der die dünne Schicht 2 angeordnet ist, d.h. nach unten, in Richtung des Ventilsitzes 50. Durch diese Auslenkung der Membran 49 wird der Dichtblock 45 gegen den Ventilsitz 50 gepreßt. Der Auslaß 47 wird so verschlossen.Die hier in der Ausgangslage gezeigte Verformung der Membran 49 stellt sich ein, wenn ein Druckunterschied zwischen dem durch die Membran 49 und die obere Siliziumplatte 41 gebildeten Hohlraum und dem Einlaß 46 besteht. In diesem Fall muß ein Teil der durch die dünne Schicht erzeugbaren Kraft dafür aufgewendet werden, diesen Druckunterschied zu überwinden. Um die zur Verfügung stehende Karft möglichst wirkungsvoll in Bewegung umzusetzten, besteht eine verbesserte Ausführungsform dieses Ventils darin, daß der Dichtblock 45 nicht an einer geschlossenen Membran 49 aufgehängt ist, sondern die Membran 49 Öffnungen aufweist. Weiterhin kann der der Dichtblock 45 an einzelnen Biegebalken aufgehängt werden. Durch diese Maßnahmen wird erreicht, daß der Druck auf beiden Seiten des Biegeelements nahezu gleich ist und nur gegen eine geringe Druckdifferenz gearbeitet werden muß.

Bei der in der Figur 8 gezeigten Anordnung von Spule und dünner Schicht 2 ist vorteilhaft, daß die Spule 44 durch Schichttechnik auf der Ober- bzw. Unterseite des Siliziumplattenverbundes aufgebracht werden kann. Dickfilmspulen sind besonders preisgünstig und können parallel auf einer Vielzahl von Ventilen gleichzeitig gefertigt werden. Dies gilt auch, wenn die Spulen in Dünnfilmtechnik erzeugt werden. Als Nachteil ist festzuhalten, daß in Figur 8 der für die Bewegung des Biegeelements nutzbare magnetostriktive Effekt der dünnen Schicht 2 etwas geringer ist.

Im geöffneten Zustand kann durch Anlegen eines entsprechenden magnetischen Wechselfeldes an die dünne Schicht 2 die Membran 49 bzw. der Dichtblock 45 in hochfrequente Schwingungen versetzt werden. Wenn die Anregung mit der Eigenfrequenz des Systems aus Dichtblock 45 und Membran 49 erfolgt, so werden auch bei geringen Leistungen große Amplituden dieser Schwingung erreicht. Bei entsprechender Steifigkeit der Membran 49 kann diese Schwingung im Bereich des Ultraschalls liegen und so die Zerstäubung einer Flüssigkeit beim Austritt durch den Auslaß 47 verbessert werden. Vorteilhaft ist dabei weiterhin, wenn der Auslaß 47 eine scharfe Abrißkante 48 aufweist. Die Zerstäubung der austretenden Flüssigkeit ist beispielsweise besonders vorteilhaft, wenn das gezeigte Ventil zur Einspritzung von Benzin in einem Motor verwendet werden soll. Durch die Anregung von hochfrequenten Schwingungen wird weiterhin die Gefahr der Verschmutzung herabgesetzt, da Ablagerungen an den Innenseiten des Ventilköpers weitgehend verhindert werden. Dies ist insbesondere für die Erhaltung der Funktionstüchtigkeit der Mikroventile, die leicht verschmutzen können, vorteilhaft.

## Patentansprüche

1. Magnetostriktiver Wandler, mit Mitteln (33, 44) ein Magnetfeld zu erzeugen und einem im Magnetfeld angeordneten Antrieb aus magnetostriktiven Material, dadurch gekennzeichnet, daß der Antrieb als dünne Schicht (1, 2, 3) auf einem Biegeelement (11, 49) aufgebracht ist, daß die dünne Schicht (1, 2, 3) aus
TB₍₁₋ₓ₎Dy₍ₓ₎Fe₂ (0<x<1) besteht, und daß die dünne Schicht (1, 2 3) aus einem Metalldampf abgeschieden ist.

2. Magnetostriktiver Wandler nach Anspruch 1, dadurch gekennzeichnet, daß die dünne Schicht (1, 2, 3) amorph ist.

3. Magnetostriktiver Wandler nach Anspruch 1, dadurch gekennzeichnet, daß die dünne Schicht (1, 2, 3) nanokristallin mit einem mittleren Korndurchmesser von weniger als 50 Nanometern ist.

4. Magnetostriktiver Wandler nach einem der vorhergehenden Ansprüche, dadurch gekennzeichnet, daß die dünne Schicht (2, 3) strukturiert ist.

5. Magnetostriktiver Wandler Anspruch 4, dadurch gekennzeichnet, daß die dünne Schicht (3) so strukturiert ist, daß einzelne, elektrisch getrennte Bereiche entstehen.

6. Magnetostriktiver Wandler nach einem der vorhergehenden Ansprüche, dadurch gekennzeichnet, daß das Biegeelement als Biegebalken (11) oder Membran (49) ausgebildet ist.

7. Magnetostriktiver Wandler nach einem der vorhergehenden Ansprüche, dadurch gekennzeichnet, daß die dünne Schicht (1, 2, 3) in einem äußeren Magnetfeld getempert ist.

8. Magnetostriktiver Wandler nach einem der vorhergehenden Ansprüche, dadurch gekennzeichnet, daß die dünne Schicht (1, 2, 3) in einem äußeren Magnetfeld abgeschieden ist.

9. Magnetostriktiver Wandler nach einem der vorhergehenden Ansprüche, dadurch gekennzeichnet, daß die dünne Schicht (1, 2, 3) in weitere dünne Schichten (13) aus einem weichmagnetischen Material eingebettet ist.

10. Magnetostriktiver Wandler nach einem der vorhergehenden Ansprüche, dadurch gekennzeichnet, daß die dünne, magnetostriktive Schicht (1, 2, 3) mit einer Schutzschicht aus Si₃N₄, TiN, NiCr oder NiFe versehen ist.

11. Magnetostriktiver Wandler nach einem der vorhergehenden Ansprüche, dadurch gekennzeichnet, daß das Mittel ein Magnetfeld zu erzeugen als Dickfilmspule oder Dünnfilmspule (44) ausgeführt ist.

12. Magnetostriktiver Wandler nach einem der vorhergehenden Ansprüche, dadurch gekennzeichnet, daß der Antrieb in einem Ventil Verwendung findet, daß ein Fluidstrahl durch mindestens eine Einlaßöffnung (34) einströmt, daß parallel zur Flußrichtung ein Biegebalken (11) mit der dünnen Schicht (2, 3) angeordnet ist, und daß durch die Auslenkung des Biegebalkens (11) der Fluidstrahl in einen von mindestens zwei Auslaßkanälen (35, 36) lenkbar ist.

13. Magnetostriktiver Wandler nach einem der Ansprüche 1 bis 11, dadurch gekennzeichnet, daß der Antrieb in einem Ventil Verwendung findet, daß das Ventil jeweils mindestens einen Auslaß (47) und Einlaß (46) und weiterhin einen an Biegeelementen (49) aufgehängten Dichtblock (45) aufweist, daß die dünne Schicht (2) auf den Biegeelementen (49) angeordnet ist, und daß durch eine Auslenkung des Dichtblocks (45) der Auslaß (47) verschließbar ist.

14. Magnetostriktiver Wandler nach Anspruch 13, dadurch gekennzeichnet, daß bei geöffnetem Auslaß (47) das Biegeelement (49) durch das Magnetfeld zu Schwingungen in einer Eigenfrequenz des Biegeelements (49) anregbar ist.

15. Magnetostriktiver Wandler nach Anspruch 14, dadurch gekennzeichnet, daß durch die Schwingungen ein flüssiges Medium zerstäubbar ist.

16. Magnetostriktiver Wandler nach einem der Ansprüche 12 bis 15, dadurch gekennzeichnet, daß das Ventil mindestens teilweise aus Siliziumplatten (30, 31, 32, 41, 42, 43) herausstrukturiert ist.

17. Magnetostriktiver Wandler nach einem der Ansprüche 12 bis 14, dadurch gekennzeichnet, daß das Ventil mindestens teilwise aus einem Metallsubstrat, insbesondere Stahl, Nickel oder Titan herausstrukturiert ist.

18. Magnetostriktiver Wandler nach einem der Ansprüche 11 bis 17, dadurch gekennzeichnet, daß die Mittel zur Erzeugung des Magnetfelds auf der Außenseite des Ventils angeordnet sind.

## Claims

1. Magnetostrictive transducer, having means (33, 44) for producing a magnetic field and having a drive which is arranged in the magnetic field and is composed of magnetostrictive material, characterized in that the drive is applied as a thin film (1, 2, 3) on a bending element (11, 49), in that the thin film (1, 2, 3) is composed of
TB₍₁₋ₓ₎Dy₍ₓ₎Fe₂ (0<x<1), and in that the thin film (1, 2, 3) is deposited from a metal vapour.

2. Magnetostrictive transducer according to Claim 1, characterized in that the thin film (1, 2, 3) is amorphous.

3. Magnetostrictive transducer according to Claim 1, characterized in that the thin film (1, 2, 3) is nano-crystalline with a mean grain diameter of less than 50 nanometres.

4. Magnetostrictive transducer according to one of the preceding claims, characterized in that the thin film (2, 3) is structured.

5. Magnetostrictive transducer according to Claim 4, characterized in that the thin film (3) is structured such that individual, electrically isolated areas are produced.

6. Magnetostrictive transducer according to one of the preceding claims, characterized in that the bending element is designed as a bending beam (11) or membrane (49).

7. Magnetostrictive transducer according to one of the preceding claims, characterized in that the thin film (1, 2, 3) is tempered in an external magnetic field.

8. Magnetostrictive transducer according to one of the preceding claims, characterized in that the thin film (1, 2, 3) is deposited in an external magnetic field.

9. Magnetostrictive transducer according to one of the preceding claims, characterized in that the thin film (1, 2, 3) is embedded in further thin films (13) composed of a soft-magnetic material.

10. Magnetostrictive transducer according to one of the preceding claims, characterized in that the thin, magnetostrictive film (1, 2, 3) is provided with a protective layer of Si₃N₄, TiN, NiCr or NiFe.

11. Magnetostrictive transducer according to one of the preceding claims, characterized in that the means for producing a magnetic field is designed as a thick-film coil or thin-film coil (44).

12. Magnetostrictive transducer according to one of the preceding claims, characterized in that the drive is used in a valve, in that a fluid jet flows in through at least one inlet opening (34), in that a bending beam (11) having the thin film (2, 3) is arranged parallel to the flow direction, and in that the fluid jet can be guided into one of at least two outlet channels (35, 36) by the deflection of the bending beam (11).

13. Magnetostrictive transducer according to one of Claims 1 to 11, characterized in that the drive is used in a valve, in that the valve in each case has at least one outlet (47) and inlet (46) as well as a sealing block (45) which is attached to bending elements (49), in that the thin film (2) is arranged on the bending elements (49), and in that the outlet (47) can be closed by deflection of the sealing block (45).

14. Magnetostrictive transducer according to Claim 13, characterized in that, when the outlet (47) is open, the bending element (49) can be excited by the magnetic field to oscillate at a natural frequency of the bending element (49).

15. Magnetostrictive transducer according to Claim 14, characterized in that a liquid medium can be atomized by the oscillations.

16. Magnetostrictive transducer according to one of Claims 12 to 15, characterized in that the valve is structured at least partially from silicon plates (30, 31, 32, 41, 42, 43).

17. Magnetostrictive transducer according to one of Claims 12 to 14, characterized in that the valve is structured at least partially from a metal substrate, in particular steel, nickel or titanium.

18. Magnetostrictive transducer according to one of Claims 11 to 17, characterized in that the means for producing the magnetic field are arranged on the outside of the valve.

## Revendications

1. Transducteur à magnétostriction, comprenant des moyens (33, 34) de production d'un champ magnétique ainsi qu'un entraîneur placé dans le champ magnétique et fait d'un matériau magnétostrictif,
caractérisé en ce que
l'entraîneur est constitué par une couche mince (1, 2, 3) déposée sur un élément flexible (11, 49), cette couche de composition Tb₍₁₋ₓ₎ Dy₍ₓ₎ Fe₂ (0<x<1), étant déposée à partir d'une vapeur métallique.

2. Transducteur selon la revendication 1,
caractérisé en ce que
la couche mince (1, 2, 3) est amorphe.

3. Transducteur selon la revendication 1,
caractérisé en ce que
la couche mince (1, 2, 3) est nanocristalline, avec un diamètre de grains inférieur à 50 nanomètres.

4. Transducteur selon une des revendications précédentes,
caractérisé en ce que
la couche mince (2, 3) est structurée.

5. Transducteur selon la revendication 4,
caractérisé en ce que
la couche mince (3) est structurée de manière à présenter des zones individuelles, électriquement séparées.

6. Transducteur selon une des revendications précédentes,
caractérisé en ce que
l'élément flexible est constitué par une barre flexible (11) ou une membrane (49).

7. Transducteur selon une des revendications précédentes,
caractérisé en ce que
la couche mince (1, 2, 3) est adoucie dans un champ magnétique externe.

8. Transducteur selon une des revendications précédentes,
caractérisé en ce que
la couche mince (1, 2, 3) est déposée dans un champ magnétique externe.

9. Transducteur selon une des revendications précédentes,
caractérisé en ce que
la couche mince (1, 2, 3) est noyée dans d'autres couches minces (13) faites d'un matériau à magnétisme doux.

10. Transducteur selon une des revendications précédentes,
caractérisé en ce que
la couche mince magnétostrictive (1, 2, 3) est recouverte d'une couche de protection en Si₃N₄, TiN, NiCr ou NiFe.

11. Transducteur selon une des revendications précédentes,
caractérisé en ce que
le moyen servant à produire un champ magnétique est constitué par une bobine (44) à film épais ou à film mince.

12. Transducteur selon une des revendications précédentes,
caractérisé en ce que
l'entraîneur est utilisé dans une soupape, dans laquelle un jet de fluide pénètre par au moins un orifice d'entrée (34), une barre flexible (11) portant la couche mince (2) étant disposée parallèlement à la direction d'écoulement du fluide, la déviation de cette barre permettant de dévier le jet fluide pour le faire passer dans l'un d'au moins deux canaux de sortie (35, 36).

13. Transducteur selon une des revendications 1 à 11,
caractérisé en ce que
l'entraîneur est utilisé dans une soupape qui comporte au moins une sortie (47) et une entrée (46) et également un bloc d'étanchéité monté sur l'élément flexible (49), la couche mince (2) se trouvant sur l'élément flexible (49) tandis qu'une déviation du bloc d'étanchéité (45) permet d'obturer la sortie (47).

14. Transducteur selon la revendication 13,
caractérisé en ce que
l'élément flexible (49), lorsque la sortie (47) est ouverte, peut être excité par le champ magnétique de manière à vibrer à sa fréquence propre.

15. Transducteur selon la revendication 14,
caractérisé en ce que
les vibrations peuvent pulvériser un liquide.

16. Transducteur selon une des revendications 12 à 15,
caractérisé en ce que
la soupape est construite, au moins en partie, à partir de plaques de silicium (30, 31, 32, 41, 42, 43).

17. Transducteur selon une des revendications 12 à 14,
caractérisé en ce que
la soupape est construite, au moins en partie, à partir d'un substrat métallique, notamment en acier, en nickel ou en titane.

18. Transducteur selon une des revendications 11 à 17,
caractérisé en ce que
les moyens de production du champ magnétique sont placés sur la surface externe de la soupape.
